# EUROPÄISCHE PATENTSCHRIFT

(11) **EP 3 357 309 B1**
(45) Veröffentlichungstag und Bekanntmachung des Hinweises auf die Patenterteilung: **18.08.2021**
(21) Anmeldenummer: 16763196.9
(22) Anmeldetag: 02.09.2016
(51) Int. Cl.: H05K 5/00, G01L 19/14

(54) **FAHRZEUGSTEUERGERÄT**
VEHICLE CONTROL DEVICE
CALCULATEUR DE VÉHICULE

(30) Priorität: 01.10.2015 DE 102015012740
(43) Veröffentlichungstag der Anmeldung: 08.08.2018
(73) Patentinhaber: ZF CV Systems Hannover GmbH, 30453 Hannover (DE)
(72) Erfinder: HARZ, Juri, 30952 Ronnenberg (DE); KORTLANG, Tobias, 30989 Gehrden (DE)
(74) Vertreter: Koschnitzki, Thomas
(86) Internationale Anmeldenummer: PCT/EP2016/001487
(87) Internationale Veröffentlichungsnummer: WO 2017/054902

(56) Entgegenhaltungen:
- EP-A2- 1 152 231
- DE-A1- 10 037 842
- DE-A1- 10 122 330
- DE-A1-102013 220 091
- DE-A1-102014 203 301
- DE-U1-202004 020 236

## Beschreibung

Die Erfindung betrifft ein Fahrzeugsteuergerät gemäß dem Oberbegriff des Anspruchs 1.

Fahrzeugsteuergeräte dienen zur Überwachung und Steuerung einer Vielzahl von Funktionen eines Fahrzeugs. Diese arbeiten teilweise autonom und teilweise von Fahrereingriffen abhängig. Die einzelnen Fahrzeugsteuergeräte sind in der Regel auf einzelne oder einige wenige Funktionen spezialisiert, wie beispielsweise auf das Bremssystem. Somit findet sich typischerweise ein Reihe unterschiedlicher Fahrzeugsteuergeräte in einem Fahrzeug. Die hier beschriebene Erfindung eignet sich grundsätzlich für unterschiedliche Typen von Fahrzeugsteuergeräten, wird hier aber beispielhaft für Bremssteuergeräte beschrieben.

Zur Ermittlung des Istzustandes relevanter Messwerte ist ein Fahrzeugsteuergerät mit geeigneten Fahrzeugsensoren ausgestattet beziehungsweise verbunden. Die Fahrzeugsensoren sind mit dem Fahrzeugsteuergerät beziehungsweise einer im Innern eines Gehäuses des Fahrzeugsteuergeräts angeordneten elektronischen Schaltung beziehungsweise Leiterplatte elektrisch verbunden.

Der wenigstens eine Fahrzeugsensor ist dabei vorzugsweise als Drucksensor ausgebildet. Insbesondere handelt es sich um einen Drucksensor eines pneumatischen Systems, beispielsweise eines pneumatischen Bremssystems.

Im Stand der Technik sind zwei Ausführungen der elektrischen Verbindung zwischen Fahrzeugsensor und Fahrzeugsteuergerät bekannt, die abhängig vom Einbauort und von der Art des Messwerts sind.

Im ersten Fall sind die Fahrzeugsensoren als separate Einheiten ausgelegt und lediglich mit einer elektrischen Kabelverbindung mit dem Fahrzeugsteuergerät beziehungsweise dessen elektronischer Schaltung verbunden. Nachteilig hieran ist, dass der Sensor ein separates Gehäuse nebst entsprechender Befestigung ausweisen muss und vor allem dass eine elektrische Kabelverbindung aufgrund von Erschütterungen und ähnlichem auf Dauer in ihrer Zuverlässigkeit leidet. Auch ist eine Verkabelung aufwändig, insbesondere bei mehreren Sensoren.

Im zweiten Fall ist der Fahrzeugsensor direkt auf der elektronischen Schaltung beziehungsweise der elektronischen Platine angeordnet, sodass somit eine feste elektrische Verbindung vorliegt. Der entsprechende Messwert, beispielsweise ein Luftdruck oder ähnliches, beziehungsweise der Messgegenstand, wie beispielsweise ein Druckmedium, muss dann zum Fahrzeugsensor transportiert werden, beispielsweise mittels Leitungen, Umlenkungen, Schläuchen oder ähnlichem. Dies weist den Nachteil auf, dass geeignete Durchführungen und Verbindungen für beispielsweise einen Druckschlauch oder ähnliches vorgesehen werden müssen. Insbesondere bei der Anordnung mehrerer Sensoren ist diese Lösung aufwändig.

DE 10 2013 220 091 A1 offenbart einen Drucksensor zum Messen des Drucks eines Fluids, insbesondere einen Bremsdrucksensor, mit einem Druckmessumformer, welcher einen einen Druckkanal aufweisenden Druckport und eine Messmembran umfasst, die auf der dem Druckkanal abgewandten Seite druckintensive Elemente aufweist, und einer Leiterplatte mit darauf angeordneter Auswerteelektronik. Der Drucksensor ist durch einen Leiterplattenträger gekennzeichnet, der mehrere elektrische Leiter aufweist, welche die drucksensitiven Elemente elektrisch mit der Leiterplatte verbinden, wobei die elektrischen Leiter mit der Leiterplatte durch Einpressen elektrisch verbunden sind.
DE 100 37 842 A1 offenbart ein Drucksteuergerät für radschlupfgeregelte hydraulische Kraftfahrzeugbremsanlagen, das insbesondere zum automatischen Bremseingriff geeignet ist, mit einem ersten Gehäuse zur Aufnahme von mehreren Druckmittelkanälen, die mit mehreren Drucksteuerventilen und Drucksensoren im ersten Gehäuse in Verbindung stehen, mit einem am ersten Gehäuse angeordneten zweiten Gehäuse zur Aufnahme von mit den Drucksteuerventilen verbundenen elektrischen und/oder elektronischen_Bauelementen. Wenigstens eines der Drucksensorelemente ist mit einem Heizelement zu einer eigenständig handhabbaren Baugruppe zusammengefasst.

EP 1 152 231 A2 offenbart ein elektronisches Steuergerät mit einem Gehäuse und einem Deckel, welches eine Leiterplatte enthält, die mit Bauelementen und mit mindestens einem Drucksensor bestückt ist. Zur Druckzufuhr zum Drucksensor dient ein Schnorchel, welcher mit seinem unteren Teil den Drucksensor umschließt und dessen Rand gegen die Leiterplatte abgedichtet ist. Das Steuergerät ist insbesondere in sogenannten Mechatroniken, in denen sowohl elektrische als auch mechanische Signale verarbeitet werden, einsetzbar.
DE 20 2004 020 236 U1 offenbart einen Druck- und Temperatursensor mit einem Gehäuse mit Zuführung des Druckmediums, einer Druckmesszelle, einer Leiterplatte und einem Anschlussteil mit elektrischen Kontakten, wobei auf der Messzelle ein ringförmiges Kunststoffteil aufsitzt, welches den Kopf der Messzelle umfasst, auf einer Seite ein Halteteil für das Lead frame besitzt und der übrige Innenraum des Kunststoffteils mit einer Leiterplatte belegt ist und auf der Leiterplatte ein ASIC angeordnet ist.

DE 10 2014 203 301 A1 offenbart eine elektronische Steuervorrichtung mit einer Leiterplatte.

DE 101 22 330 A1 offenbart eine Bremsvorrichtung mit integriertem Drucksensormodul.

Die der Erfindung zugrundeliegende Aufgabe besteht daher darin, ein Fahrzeugsteuergerät mit einem Fahrzeugsensor bereitzustellen, das die vorstehend genannten Nachteile beseitigt. Insbesondere sollen eine zuverlässige und haltbare mechanische und elektrische Verbindungen zwischen Fahrzeugsteuergerät und Fahrzeugsensor geschaffen werden.

Die vorstehende genannte Aufgabe wird durch ein Fahrzeugsteuergerät mit den Merkmalen des Anspruchs 1 gelöst. Demnach ist der Fahrzeugsensor mit dem Gehäuse des Fahrzeugsteuergeräts verbunden. Das Gehäuse weist eine hohe mechanische Stabilität auf und kann somit zur zuverlässigen Verbindung mit dem Fahrzeugsensor dienen. Insbesondere wird eine Belastung der Leiterplatte der elektronischen Schaltung verringert.

Bevorzugt weist der Fahrzeugsensor ein Sensorgehäuse auf, das mit dem Gehäuse des Fahrzeugsteuergeräts verbunden ist. Durch Verbindung der beiden Gehäuse miteinander wird eine sichere Befestigung erreicht. Der Fahrzeugsensor beziehungsweise das Sensorgehäuse ist mechanisch mit dem Gehäuse verbunden. Die mechanische Verbindung bietet eine sichere Halterung. Besonders bevorzugt erfolgt die Befestigung ausschließlich mit dem Gehäuse. Letzteres stellt sicher, dass keine mechanische Belastung, beispielsweise elektronischer Komponenten oder ähnlichem erfolgt.

Erfindungsgemäß ist eine Rastverbindung und/oder-eine Bajonettverbindung zwischen dem Fahrzeugsensor beziehungsweise dem Sensorgehäuse einerseits und dem Gehäuse andererseits ausgebildet. Hierdurch kann eine leichte, vorzugsweise werkzeuglose Montage erreicht werden.

Vorzugsweise ist die Rastverbindung durch wenigstens einen Rasthaken gebildet. Dieser dient insbesondere zur Aufnahme und Fixierung des Fahrzeugsensors. Damit wird eine lösbare und gleichzeitig haltbare Befestigung des Fahrzeugsensors am Gehäuse ermöglicht.

Erfindungsgemäß ist der Fahrzeugsensor durch eine flexible elektrische Verbindung mit der elektronischen Schaltung verbunden. Als flexible elektrische Verbindung kommt insbesondere ein Kabel, wenigstens eine Leiterbahn, wenigstens ein Federkontakt oder ähnliches in Betracht. Es ist wenigstens ein Einpresskontakt vorgesehen, bevorzugt in Kombination mit einem Kabel und/oder einer Leiterbahn. Hierdurch wird die Übertragung mechanischer Bewegungen vom Fahrzeugsensor auf die elektronische Schaltung beziehungsweise elektronische Platine weitestgehend vermieden.

Insbesondere ist eine lösbare und/oder flexible Verbindung zwischen dem Fahrzeugsensor beziehungsweise dem Sensorgehäuse und dem Gehäuse ausgebildet. Durch eine lösbare Verbindung wird ein einfacher Austausch des Fahrzeugsensors ermöglicht, beispielsweise bei einem Defekt. Durch eine flexible Verbindung können Relativbewegungen zwischen Fahrzeugsensor und Gehäuse des Fahrzeugsteuergeräts abgefangen werden. Dies sorgt insbesondere für eine Verringerung der Belastung auf die Gehäuseteile. Eine flexible Verbindung kann beispielsweise durch elastische Komponenten, wie beispielsweise eine Gummidichtung oder ähnlichem erfolgen.

Bevorzugt ist eine dauerhaft unlösbare Verbindung zwischen Fahrzeugsensor und dem Sensorgehäuse und dem Gehäuse ausgebildet. Hierdurch wird erreicht, dass der Fahrzeugsensor fest mit dem Fahrzeugsteuergerät verbunden ist. Zur Gewährleistung einer hohen Betriebssicherheit müssen dann Fahrzeugsteuergerät und Fahrzeugsensor im Falle des Defekts einer Komponente komplett ausgetauscht werden, um so nur zusammengehörige Komponenten als Ersatz neu zu verbauen.

Das Gehäuse weist insbesondere eine Halterung beziehungsweise Aufnahme für den Fahrzeugsensor auf. In dieser Halterung beziehungsweise Aufnahme kann der Fahrzeugsensor eingesetzt werden, insbesondere mit dessen Gehäuse. Die Halterung beziehungsweise Aufnahme ist vorzugsweise im Bereich einer Wand des Gehäuses vorgesehen. Insbesondere ist der Fahrzeugsensor beziehungsweise das Sensorgehäuse formschlüssig zur Halterung beziehungsweise Aufnahme ausgebildet. Damit wird ein sicheres und haltbares Befestigen des Fahrzeugsensors am Fahrzeugsteuergerät sichergestellt.

In einer nicht anspruchsgemäßen Alternative kann der Fahrzeugsensor insbesondere innen im Gehäuse beziehungsweise im Innern des Gehäuses angeordnet sein. Vorzugsweise erfolgt dann die Anordnung des Fahrzeugsensors im Bereich einer Gehäusewand und/oder an einer Gehäusewand. Damit wird einerseits ein guter elektrischer Kontakt und gegebenenfalls eine Versiegelung des Gehäuses gegenüber der Umgebung erreicht. Andererseits kann ein Durchbruch einen Kontakt des Sensors nach Draußen zur Aufnahme von Messwerten ermöglichen.

In einer nicht anspruchsgemäßen Alternative kann der Fahrzeugsensor außen am Gehäuse angeordnet sein, vorzugsweise außerhalb des Gehäuses. Die Anordnung erfolgt dann vorzugsweise im Bereich einer Gehäusewand. Hierdurch wird eine einfache Montage des Fahrzeugsensors am Fahrzeugsteuergerät ermöglicht. Außerdem kann auf einfache Weise der Kontakt zu einer Messdatenquelle sichergestellt werden.

Der Fahrzeugsensor ist vorzugsweise mittels einer starren Verbindung mit der Messwertquelle verbunden. Es handelt sich dabei insbesondere um eine pneumatische Verbindung. Besonders bevorzugt ist hierzu ein Stutzen, insbesondere ein starrer Stutzen vorgesehen

Der Fahrzeugsensor kann insbesondere alternativ mittels einer flexiblen Verbindung mit der Messwertquelle verbunden sein. Es handelt sich dabei insbesondere um eine pneumatische Verbindung. Vorzugsweise ist ein Schlauch, insbesondere Druckschlauch vorgesehen. Zur Messdatenaufnahme muss die Messwertquelle mit dem Fahrzeugsensor verbunden sein. Durch eine flexible Verbindung wird erreicht, dass Relativbewegungen, beispielsweise durch Vibrationen oder ähnliches einerseits nicht übertragen und andererseits die mechanische Stabilität geringstmöglich beeinflusst wird. Durch Vorsehen eines Schlauches zur Druckmessung kann das entsprechende Druckmedium bis an den Fahrzeugsensor herangeführt werden.

Die Montage wird auf die erfindungsgemäße Weise durch einfaches Zusammenstecken gegenüber den bekannten Verfahren erleichtert. Lediglich bei der Montage müssen die Leiterplatte und die Kontakte positionsgenau gehalten werden. Hierdurch wird auch die Übertragung mechanischer Bewegungen vom Fahrzeugsensor auf die elektronische Schaltung beziehungsweise elektronische Platine weitestgehend vermieden.

Ein bevorzugtes Ausführungsbeispiel der Erfindung wird im Folgenden anhand der Zeichnungen näher beschrieben. In diesen zeigen:
- Fig. 1: ein erstes Ausführungsbeispiel eines erfindungsgemäßen Fahrzeugsteuergeräts mit einem Fahrzeugsensor, und
- Fig. 2: ein zweites Ausführungsbeispiel eines erfindungsgemäßen Fahrzeugsteuergeräts mit einem Fahrzeugsensor.

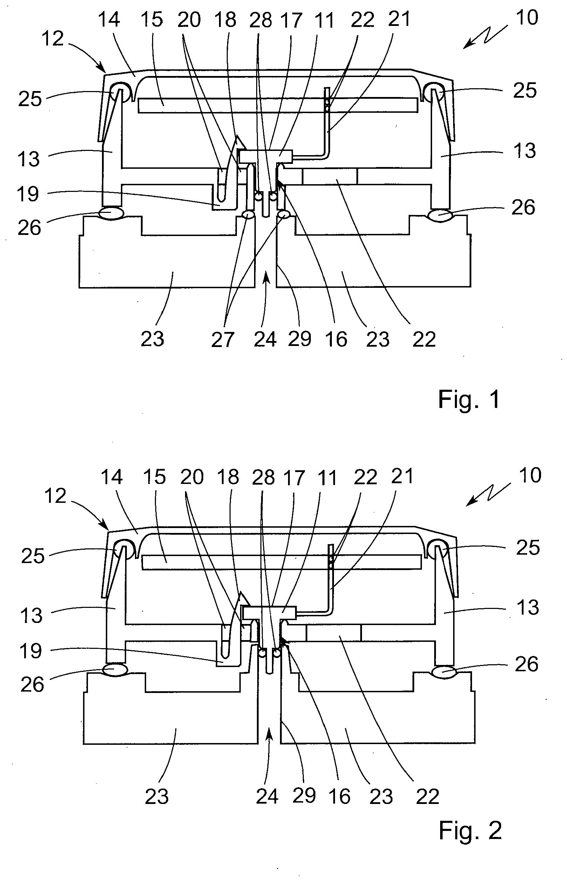

Die Fig. 1 zeigt eine seitliche Schnittansicht eines Fahrzeugsteuergeräts 10 mit einem Fahrzeugsensor 11. Beim Fahrzeugsteuergerät 10 handelt es sich im gezeigten Ausführungsbeispiel um ein Bremssteuergerät. Dementsprechend ist der Fahrzeugsensor 11 als Drucksensor ausgelegt. Bei einem pneumatischen Bremssystem handelt es sich insbesondere um einen Luftdrucksensor für Pressluft.

Das Fahrzeugsteuergerät 10 weist ein Gehäuse 12 auf. Das Gehäuse 12 ist als sogenanntes Elektronikgehäuse ausgebildet. Es weist ein Gehäuseunterteil 13 und einen Gehäusedeckel 14 auf. Um die Elektronik vor Feuchtigkeit zu schützen, bilden diese typischerweise einen gegenüber der Umgebung zumindest spritzwasserdicht verschlossenen Innenraum aus. In diesem Innenraum, dem Innern des Gehäuses 12, ist eine Leiterplatte 15 angeordnet. Auf der Leiterplatte 15 sind die elektronischen Bauelemente der elektronischen Schaltung des Fahrzeugsteuergeräts 10 angeordnet.

Zum Teil im Innern des Gehäuses 12 und zum Teil außerhalb ist der Sensor 11 angeordnet. Im gezeigten Ausführungsbeispiel ist der Fahrzeugsensor 11 in die untere Bodenplatte des Gehäuseunterteils 13 eingesetzt. Hierzu ist eine Aussparung 16 im Gehäuseunterteil 13 vorgesehen. Die Aussparung 16 korrespondiert mit den Außenmaßen des eingesteckten Fahrzeugsensors 11. In diese Aussparung ist der Fahrzeugsensor 11 vom Inneren des Gehäuses 12 aus eingesteckt.

Der Fahrzeugsensor 11 ist hier lediglich schematisch dargestellt. Die gezeigten Konturen entsprechend tatsächlich diejenigen eines entsprechenden Sensorgehäuses 17 des Fahrzeugsensors 11. Die eigentliche Sensorik des Sensors 11 ist im Innern dieses Sensorgehäuses 17 angeordnet, wurde hier aber der Übersichtlichkeit halber nicht dargestellt. Die Abmessungen des Sensorgehäuses 17 korrespondieren in einem unterem eingesteckten Bereich mit den Abmessungen der Aussparung 16. An einem oberen Bereich weist das Gehäuse 17 eine verbreiterte Stelle auf, die verhindert, dass das Sensorgehäuse 17 durch die Aussparung 16 hindurch rutscht.

Um ein Herausrutschen des Fahrzeugsensors 11 aus der Aussparung 16 in vertikaler Richtung nach oben zu verhindern, ist eine Rastverbindung vorgesehen. Hierzu ist wenigstens ein Rasthaken 18 an einem Federelement 19 am Gehäuseunterteil 13 vorgesehen. Zur Vereinfachung der Herstellung sind sowohl das Federelement 19 wie auch der wenigstens eine Rasthaken 18 einstückig aus dem Material des Gehäuseunterteils 13 hergestellt. Tatsächlich handelt es sich beim Gehäuseunterteil 13 typischerweise um ein einstückig hergestelltes Formteil, beispielsweise ein Spritzgussteil. Zur Vereinfachung der Montage und für besseren Halt können auch mehrere Rasthaken 18 vorgesehen sein.

Um eine Beweglichkeit des Rasthakens 18 mit dem Federelement 19 zu gewährleisten, ist Bereich des Gehäuseunterteils 13 eine Aussparung 20 im Bewegungsbereich des Rasthakens 18 vorgesehen. Diese Aussparung 20 ermöglicht eine in Zeichnungsebene horizontale Bewegung des Rasthakens 18.

Der Rasthaken 18 ist dabei so eingerichtet, dass er nach rechts in der Zeichnungsebene ausfedert, um so das Sensorgehäuse 17 oberhalb zu umgreifen und mit Federkraft seitlich an diesem anzuliegen. Somit wird verhindert, dass der Fahrzeugsensor 11 in Zeichnungsebene nach oben entgegen dem Rasthaken 18 aus der Aussparung 16 heraus bewegt werden kann. Um ein Entfernen des Fahrzeugsensors 11 zu ermöglichen, ist dementsprechend vorher der Rasthaken 18 in Zeichnungsebene nach links gegen die Federkraft des Federelements 19 aus dem Eingriff des Sensorgehäuses 17 zu bewegen.

Der Fahrzeugsensor 11 ist außerdem mittels einer elektrischen Verbindung, wie beispielsweise einem hier gezeigten Stanzgitter 21 oder auch einem Kabel beziehungsweise anderen elektrischen Leitern, mit der Leiterplatte 15 elektrisch verbunden. Durch Verwendung eines flexiblen elektrischen Leiters, wie des Stanzgitters oder eines Kabels, wird die mechanische Belastung der Leiterplatte 15 minimiert.

Die leitende Verbindung zwischen dem Stanzgitter 21 und der Leiterplatte 15 wird mittels Einpresskontakten 22 hergestellt. Die Einpresskontakte 22 werden in entsprechende Öffnungen der Leiterplatte 15 zur Kontaktierung eingebracht. Sie halten dort durch jeweils eigene Federwirkung.

Aufgrund der Verwendung der Einpresskontakte 22 ist es nur während des Herstellungs- beziehungsweise Montageprozesses erforderlich, die Leiterplatte 15 positionsgenau zu halten. Sobald die elektrische Verbindung hergestellt ist, sichern die Einpresskontakte 22 diese dauerhaft. Gegebenenfalls, in Ausführungen die nicht der Erfindung entsprechen, können statt Einpresskontakten 22 aber grundsätzlich auch andere, eventuell weniger vorteilhafte Verbindungsarten vorgesehen sein, wie Lötverbindungen oder ähnliches.

Um die elektrische Verbindung zwischen dem Fahrzeugsensor 11 und der Leiterplatte 15 mit wenig Aufwand herstellen zu können, ist eine Aussparung 22 im Bereich des Gehäuseunterteils 13 ausgebildet. Durch diese Aussparung 22 hindurch kann die Verbindung zwischen Leiterplatte 15 und den vorgesehenen elektrischen Leitern während der Montage geschlossen werden. Insbesondere kann der Einpressvorgang der Einpresskontakte 22 in die Leiterplatte 15 auf einfache Weise durch die Aussparung 22 hindurch erfolgen. Gleichzeitig bildet der Sockel 23 einen Stutzen 29 zur Durchleitung des Druckmediums wie insbesondere Pressluft aus.

Das Gehäuse 12 ist mit einem Sockel 23 des zu steuernden Gerätes des Fahrzeugs verbunden. Dieser bildet den unteren Abschluss des Gehäuses 12. Der Sockel 23 dient typischerweise auch zur Befestigung des Fahrzeugsteuergeräts 10 am zugehörigen Fahrzeug. Der Sockel 23 weist dabei einen Stutzen 29 auf zur Durchleitung des Druckmediums von der Pneumatik zum Sensor 11, um den Druck mit dem Sensor 11 messen zu können. Dabei wird das Gehäuse 12 mit dem Gehäuseunterteil 13 und dem dort angeordneten Fahrzeugsensor 11 in den Stutzen 29 bei der Montage eingesetzt. Hierdurch wird die Druckverbindung hergestellt und gleichzeitig eine Abdichtung erreicht.

Durch den Sockel 23 hindurch kann alternativ im Bereich einer Aussparung 24 auch ein hier nicht dargestellter Schlauch bis zum Fahrzeugsensor 11 geführt sein. Dieser Schlauch kann beispielsweise als Druckschlauch ausgebildet sein und ein entsprechendes zu messendes Druckmedium, wie beispielsweise Pressluft, zum Fahrzeugsensor 11 führen.

Die Bestandteile des Gehäuses 12 und des Sockels 23 sind mittels mehrerer Dichtungen 25, 26, 27 gegeneinander abgedichtet.

Die Dichtungen 25 sind dabei zur Abdichtung des Gehäusedeckels 14 gegenüber dem Gehäuseunterteil 13 vorgesehen. In dem gegenüber der Umgebung abgeschlossenen Innenraum dieses in der Zeichnung oberen Gehäuseteils ist die Elektronik, also in diesem Fall die Leiterplatte 15 und der obere Teil des Sensors 11, angeordnet. Zur Abdichtung des Gehäuseunterteils 13 gegenüber dem Sockel 23 beziehungsweise dem Stutzen 29 des zu steuernden Gerätes des Fahrzeugs sind zwei weitere Dichtungen 27 vorgesehen. Damit ist auch die Aussparung 24 zur Durchführung des Druckmediums gegenüber dem Innenraum des Gehäuses abgedichtet.

Zur Abdichtung des Fahrzeugsensors 11 gegenüber der Umgebung ist außerdem wenigstens eine Dichtung 28 vorgesehen. Diese kann beispielsweise als O-RingDichtung oder ähnlich ausgeführt sein. Sie sorgt dafür, dass die Aussparung 24 vom Innenraum des die elektronischen Bauelemente beinhaltenden oberen Gehäuseteils zwischen Gehäusedeckel 14 und Gehäuseunterteil 13 abgedichtet ist.

Das zweite Ausführungsbeispiel der Fig. 2 zeigt eine etwas modifizierte Ausbildung des Sockels 23.

Der Sockel 23 ist hier mit der Dichtung 28 direkt gegenüber dem Fahrzeugsensor 11 abgedichtet. Damit wird der Außenraum des Gehäuses 12 vom Innenraum desselben getrennt. Eine mehrfache Abdichtung, wie im ersten Ausführungsbeispiel, ist hierbei zwar nicht erforderlich. Somit werden gegenüber dem ersten Ausführungsbeispiel Dichtungen eingespart. Allerdings erfolgt im ersten Ausführungsbeispiel bereits eine Abdichtung des Sensors 11 gegenüber dem Gehäuseunterteil 13. Dies erfolgt hier erst nach Aufsetzen auf den Sockel 23. Beide Varianten weisen unterschiedliche Vorteile bei der Herstellung beziehungsweise im tatsächlichen Einsatz auf. Je nach Einsatzzweck kann eine der beiden gezeigten Ausführungsbeispiele oder es können auch weitere erfindungsgemäße Varianten verwendet werden.

## Patentansprüche

1. Fahrzeugsteuergerät mit einer elektronischen Schaltung, mit einer Leiterplatte (15), einem Gehäuse (12) und wenigstens einem Fahrzeugsensor (11), wobei auf der Leiterplatte (15) die elektronischen Bauelemente der elektronischen Schaltung des Fahrzeugsteuergeräts (10) angeordnet sind, wobei der wenigstens eine Fahrzeugsensor (11) als Drucksensor ausgebildet ist und wobei der wenigstens eine Fahrzeugsensor (11) mit der elektronischen Schaltung zur Aufnahme von Messwerten elektrisch verbunden ist, wobei der Fahrzeugsensor (11) mittels einer flexiblen elektrischen Verbindung mit der Leiterplatte (15) verbunden ist, wobei die flexible elektrische Verbindung über einen Einpresskontakt (22) mit der Leiterplatte (15) verbunden ist, wobei eine Rastverbindung und/oder Bajonettverbindung zwischen dem Fahrzeugsensor (11) beziehungsweise dem Sensorgehäuse (17) und dem Gehäuse (12) des Fahrzeugsteuergerätes ausgebildet ist,
wobei der Fahrzeugsensor (11) zum Teil im Innern des Gehäuses (12) und zum Teil außerhalb ist, wobei eine Aussparung (16) im Gehäuseunterteil (13) vorgesehen ist, die mit den Außenmaßen des eingesteckten Fahrzeugsensors (11) korrespondiert und in die der Fahrzeugsensor (11) vom Inneren des Gehäuses (12) aus eingesteckt ist.

2. Fahrzeugsteuergerät nach Anspruch 1, **dadurch gekennzeichnet, dass** der Fahrzeugsensor (11) ein Sensorgehäuse (17) aufweist, das mechanisch ausschließlich mit dem Gehäuse (12) verbunden ist.

3. Fahrzeugsteuergerät nach Anspruch 1, **dadurch gekennzeichnet, dass** die Rastverbindung durch wenigstens einen Rasthaken zur Aufnahme und Fixierung des Fahrzeugsensors gebildet ist.

4. Fahrzeugsteuergerät nach einem der vorhergehenden Ansprüche, **dadurch gekennzeichnet, dass** der Fahrzeugsensor (11) durch eine flexible elektrische Leitung mit der elektrischen Schaltung beziehungsweise deren Leiterplatte (15) verbunden ist, vorzugsweise mittels wenigstens eines Stanzgitters (21), eines Kabels, einer Leiterbahn, eines Federkontaktes oder ähnlichem.

5. Fahrzeugsteuergerät nach einem der vorhergehenden Ansprüche, **dadurch gekennzeichnet, dass** das Gehäuse (12) eine Halterung und/oder Aufnahme (16) für den Fahrzeugsensor (11) aufweist, wobei die Halterung beziehungsweise Aufnahme (16) vorzugsweise im Bereich einer Wand des Gehäuses (12) vorgesehen ist und/oder wobei der Fahrzeugsensor (11) und/oder das Sensorgehäuse (17) insbesondere formschlüssig zur Halterung beziehungsweise Aufnahme ausgebildet ist.

6. Fahrzeugsteuergerät nach einem der vorhergehenden Ansprüche, **dadurch gekennzeichnet, dass** eine starre pneumatische Verbindung des Fahrzeugsensors (11) mit der Messwertquelle vorgesehen ist, vorzugsweise einem insbesondere rohrförmigen Stutze, wobei die Verbindung zwischen dem Fahrzeugsensor (11) beziehungsweise dem Sensorgehäuse (17) und dem Gehäuse vorzugsweise steckbar ist.

7. Fahrzeugsteuergerät nach einem der vorhergehenden Ansprüche, **dadurch gekennzeichnet, dass** der Fahrzeugsensor (11) mittels einer flexiblen pneumatischen Verbindung, insbesondere Schlauchverbindung, und/oder mittels einer starren Verbindung, vorzugsweise eines starren Stutzens (29), mit der Messwertquelle verbunden ist.

## Claims

1. A vehicle control device comprising an electronic circuit, a circuit board (15), a housing (12) and at least one vehicle sensor (11), wherein the electronic components of the electronic circuit of the vehicle control device (10) are arranged on the circuit board (15), wherein the at least one vehicle sensor (11) is configured as a pressure sensor and wherein the at least one vehicle sensor (11) is electrically connected to the electronic circuit for receiving measurement values, wherein the vehicle sensor (11) is connected to the circuit board (15) by means of a flexible electrical connection, wherein the flexible electrical connection is connected to the circuit board (15) via a press-fit contact (22), wherein a latching connection and/or a bayonet connection is configured between the vehicle sensor (11) or the sensor housing (17) and the housing (12) of the vehicle control device,
wherein the vehicle sensor (11) is partially inside the housing (12) and partially outside, wherein a recess (16) is provided in the housing lower part (13), which corresponds with the outside measurements of the plugged in vehicle sensor (11) and into which the vehicle sensor (11) is plugged from the inside of the housing (12).

2. The vehicle control device according to claim 1, **characterized in that** the vehicle sensor (11) comprises a sensor housing (17) that is mechanically connected solely to the housing (12).

3. The vehicle control device according to claim 1, **characterized in that** the latching connection is formed by at least one latching hook for receiving and fixing the vehicle sensor.

4. The vehicle control device according to any of the preceding claims, **characterized in that** the vehicle sensor (11) is connected by a flexible electrical line to the electrical circuit or its circuit board (15), preferably by means of at least one lead frame (21), a cable, a conductor track, a spring contact or the like.

5. The vehicle control device according to any of the preceding claims, **characterized in that** the housing (12) comprises a holder and/or receptacle (16) for the vehicle sensor (11), wherein the holder or receptacle (16) is preferably provided in the region of a wall of the housing (12) and/or wherein the vehicle sensor (11) and/or the sensor housing (17) is configured in particular in a form-fitting manner to the holder or receptacle.

6. The vehicle control device according to any of the preceding claims, **characterized in that** a rigid pneumatic connection of the vehicle sensor (11) to the source of the measurement values is provided, preferably an in particular tubular support, wherein the connection between the vehicle sensor (11) or the sensor housing (17) and the housing is preferably pluggable.

7. The vehicle control device according to any of the preceding claims, **characterized in that** the vehicle sensor (11) is connected to the source of the measurement values by means of a flexible pneumatic connection, in particular a hose connection, and/or by means of a rigid connection, preferably a rigid support (29).

## Revendications

1. Calculateur de véhicule avec un circuit électronique, avec une carte de circuits imprimés (15), un boîtier (12) et au moins un capteur de véhicule (11), dans lequel les composants électroniques du circuit électronique du calculateur de véhicule (10) sont disposés sur la carte de circuits imprimés (15), dans lequel l'au moins un capteur de véhicule (11) est réalisé sous la forme d'un capteur de pression et dans lequel l'au moins un capteur de véhicule (11) est relié électriquement au circuit électronique pour l'enregistrement de valeurs de mesure, dans lequel le capteur de véhicule (11) est relié à la carte de circuits imprimés (15) au moyen d'une liaison électrique flexible, dans lequel la liaison électrique flexible est reliée à la carte de circuits imprimés (15) par l'intermédiaire d'un contact inséré à force (22), dans lequel une liaison par encliquetage et/ou un raccord à baïonnette est réalisé(e) entre le capteur de véhicule (11) ou le boîtier de capteur (17) et le boîtier (12) du calculateur de véhicule,
dans lequel le capteur de véhicule (11) est en partie à l'intérieur du boîtier (12) et en partie à l'extérieur, dans lequel un évidement (16) est prévu dans la partie inférieure de boîtier (13), qui correspond aux dimensions extérieures du capteur de véhicule (11) introduit et dans lequel le capteur de véhicule (11) est introduit à partir de l'intérieur du boîtier (12).

2. Calculateur de véhicule selon la revendication 1, **caractérisé en ce que** le capteur de véhicule (11) présente un boîtier de capteur (17), qui est relié mécaniquement exclusivement au boîtier (12).

3. Calculateur de véhicule selon la revendication 1, **caractérisé en ce que** la liaison par encliquetage est formée par au moins un crochet d'encliquetage pour la réception et la fixation du capteur de véhicule.

4. Calculateur de véhicule selon l'une quelconque des revendications précédentes, **caractérisé en ce que** le capteur de véhicule (11) est relié par une ligne électrique flexible au circuit électrique ou à la carte de circuits imprimés (15) de celui-ci, de préférence au moyen d'au moins une grille de connexion (21), d'un câble, d'un tracé conducteur, d'un contact élastique ou similaire.

5. Calculateur de véhicule selon l'une quelconque des revendications précédentes, **caractérisé en ce que** le boîtier (12) présente un élément de retenue et/ou logement (16) pour le capteur de véhicule (11), dans lequel l'élément de retenue ou le logement (16) est prévu de préférence dans la zone d'une paroi du boîtier (12) et/ou dans lequel le capteur de véhicule (11) et/ou le boîtier de capteur (17) est réalisé en particulier par complémentarité de formes pour la retenue ou le logement.

6. Calculateur de véhicule selon l'une quelconque des revendications précédentes, **caractérisé en ce qu'**une liaison pneumatique rigide du capteur de véhicule (11) à la source de valeurs de mesure est prévue, de préférence une tubulure en particulier tubulaire, dans lequel la liaison entre le capteur de véhicule (11) ou le boîtier de capteur (17) et le boîtier est de préférence enfichable.

7. Calculateur de véhicule selon l'une quelconque des revendications précédentes, **caractérisé en ce que** le capteur de véhicule (11) est relié à la source de valeurs de mesure au moyen d'une liaison pneumatique flexible, en particulier liaison tubulaire, et/ou au moyen d'une liaison rigide, de préférence d'une tubulure rigide (29).
